# EUROPEAN PATENT SPECIFICATION

(11) **EP 4 287 878 B1**
(45) Date of publication and mention of the grant of the patent: **06.11.2024**
(21) Application number: 22701617.7
(22) Date of filing: 25.01.2022
(51) Int. Cl.: A24F 40/70, A24F 40/46, A24F 40/20, H05B 3/46

(54) **HEATING CHAMBER FOR AN AEROSOL GENERATING DEVICE**
HEIZKAMMER FÜR EINE AEROSOLERZEUGUNGSVORRICHTUNG
CHAMBRE DE CHAUFFAGE POUR DISPOSITIF DE GÉNÉRATION D'AÉROSOL

(30) Priority: 08.02.2021 EP 21155873
(43) Date of publication of application: 13.12.2023
(73) Proprietor: JT International SA, 1202 Geneva (CH)
(72) Inventor: WRIGHT, Alec, Guildford Surrey GU2 7SU (GB)
(74) Representative: Gill Jennings & Every LLP
(86) International application number: PCT/EP2022/051543
(87) International publication number: WO 2022/167259

(56) References cited:
- EP-A1- 0 703 734
- EP-B1- 0 703 734
- WO-A1-2019/219865
- WO-A1-2020/149507
- CN-A- 110 742 321
- US-A1- 2020 046 028

## Description

The present invention relates to an aerosol generating device, and a method of manufacturing a heating chamber for the aerosol generating device. The disclosure is particularly applicable to a portable aerosol generation device, which may be self-contained and low temperature. Such devices may heat, rather than burn, tobacco or other suitable aerosol substrate materials by conduction, convection, and/or radiation, to generate an aerosol for inhalation.

The popularity and use of reduced-risk or modified-risk devices (also known as vaporisers) has grown rapidly in the past few years as an aid to assist habitual smokers wishing to quit using traditional tobacco products such as cigarettes, cigars, cigarillos, and rolling tobacco. Various devices and systems are available that heat or warm aerosolisable substances as opposed to burning tobacco in conventional tobacco products.

A commonly available reduced-risk or modified-risk device is the heated substrate aerosol generation device or heat-not-burn (HNB) device. Devices of this type generate an aerosol or vapour by heating an aerosol substrate (i.e. consumable) that typically comprises moist leaf tobacco or other suitable aerosolisable material to a temperature typically in the range 150°C to 300°C. Heating an aerosol substrate, but not combusting or burning it, releases an aerosol that comprises the components sought by the user but not the undesirable by-products of combustion. In addition, the aerosol produced by heating the tobacco or other aerosolisable material does not typically comprise the burnt or bitter taste that may result from combustion that can be unpleasant for the user.

Within known heat-not-burn devices, it is desirable to improve the efficiency of the heating process, whilst also ensuring a reliable operation of the device.

CN 110 742 321 A discloses a side-by-side segmented heating structure for heating a smoke-emitting medium to emit smoke and a low-temperature smoking appliance therefor. WO 2019/219865 A1 discloses a mechanical atomizer with a vibrating mesh.

According to a first aspect of the invention, there is provided a method of manufacturing a heating chamber for an aerosol generating device, as set out in appended claim 1, the method comprising: providing a heating chamber comprising a thermally conductive shell and an opening for receiving an aerosol substrate within the heating chamber; depositing a layer of electrically insulating material onto an outer surface of the thermally conductive shell of the heating chamber using vacuum deposition; and attaching a heating element to the heating chamber such that the heating element is in contact with the layer of electrically insulating material, wherein the layer of electrically insulating material prevents any contact between the heating element and the thermally conductive shell.

In this way, a more efficient heating assembly is provided compared with known aerosol generating devices. The use of vacuum deposition allows for a very thin and uniform layer of electrically insulating material to be deposited between the thermally conductive shell and the heating element. Vacuum deposition further allows for materials to be deposited which have a high electric break down voltage but also a high thermal conductivity to ensure efficient heat transfer through the layer of electrically insulating material to the heating chamber. The arrangement and properties of the electrically insulating material layer acts to prevent a short circuit between the thermally conductive shell and the heating element, and the reduced thickness of the electrically insulating material layer optimises the thermal energy transfer to the thermally conductive shell. Hence, the method of manufacturing provides a heating chamber for an aerosol generating device that is able to operate with improved efficiency and reliability. The step of depositing a layer of electrically insulating material onto an outer surface of the thermally conductive shell of the heating chamber using vacuum deposition may comprise depositing the layer with one or both of physical vapour deposition and chemical vapour deposition.

Preferably, the method comprises depositing the layer of electrically insulating material using chemical vapour deposition. In this way, the layer of electrically insulating material may be deposited having a high purity and density. Moreover, chemical vapour deposition allows for the deposition of electrically insulating material with an even thickness across the surface of the thermally conductive shell, thereby ensuring consistent thermal and electrical properties across the layer.

Preferably, the electrically insulating material comprises at least one of: silicon oxide; diamond; and diamond-like carbon (DLC). In this way, the layer of electrically insulating material separating the thermally conductive shell and the heating element has a high electrical breakdown voltage and a high thermal conductivity. This further reduces the likelihood of a short circuit occurring between the thermally conductive shell and the heating element and also improves the efficiency of thermal energy transfer to the thermally conductive shell. In one example, the electrically insulating layer may comprise a functionalized silica-like coating, e.g. a-SiO_{X}:CH_{Y}, which may be referred to as Dursan^{™}.

Preferably, the thickness of the layer of electrically insulating material is between 0.3 µm and 5 µm. For example, the thickness of the deposited layer of electrically insulating material may be 0.3 µm, 0.4 µm, 0.5 µm, 1 µm, 1.5 µm, 2 µm, 2.5 µm, 3 µm, 4 µm, or 5 µm. In particular, the layer of electrically insulating material comprising a-SiO_{X}:CH_{Y} preferably has a thickness of between 0.4 µm and 1.6 µm.

The method further comprises: providing a thin film heater comprising the heating element and a flexible backing film on which the heating element is supported; and attaching the thin film heater to the heating chamber with the heating element against the layer of electrically insulating material. In this way, a compact heating chamber is produced without compromising on thermal or electrical properties.

The backing film comprises polyimide or polyether ether ketone (PEEK). PEEK is a highly temperature resistant material, which is ideal for use in components arranged near a source of heat. When used in components directly in contact with the heating components, PEEK reduces the heat conduction to other components in the device.

Preferably, the heating chamber is a tubular heating chamber comprising a tubular thermally conductive shell. In one embodiment, the method comprises wrapping the heating element around the heating chamber with the heating element against the layer of electrically insulating material. In another embodiment, the method comprises wrapping the thin film heater around the heating chamber with the heating element against the layer of electrically insulating material.

Preferably, the method further comprises: wrapping a heat shrink film around the heating chamber to secure the heating element to the heating chamber. In this way, the heating element is ensured to remain in contact with the heating chamber, whilst also maintaining a compact arrangement of the heating assembly.

Preferably, the method further comprises: depositing the layer of electrically insulating material using plasma enhanced chemical vapour deposition. In this way, plasma enhanced chemical vapour deposition allows for the use of lower film formation temperatures, more even film thickness, and the improved ability to form film layers with a three-dimensional structure.

Preferably, depositing the layer of electrically insulating material using plasma enhanced chemical vapour deposition comprises using a radio frequency electrical excitation source and a carrier gas comprising CH₄ to deposit a thin film comprising diamond-like-carbon, DLC, or diamond.

Preferably, depositing the layer of electrically insulating material using plasma enhanced chemical vapour deposition comprises using a microwave frequency electrical excitation source and a carrier gas comprising silane to deposit a thin film comprising silicon oxide, e.g. silicon dioxide or a-SiO_{X}:CH_{Y}.

According to a second aspect of the invention, there is provided a heating chamber for an aerosol generating device manufactured by the method of the first aspect, as set out in appended claim 11.

According to a third aspect of the invention, there is provided an aerosol generating device comprising the heating chamber of the second aspect, as set out in appended claim 12.

Embodiments of the invention are now described, by way of example, with reference to the drawings, in which:
Figure 1 is an exemplary aerosol generating device according to an embodiment of the invention;
Figure 2 is a schematic cross-sectional view of a heating chamber according to an embodiment of the invention; and
Figure 3 is a flow diagram showing method steps for manufacturing the heating chamber according to an embodiment of the invention.

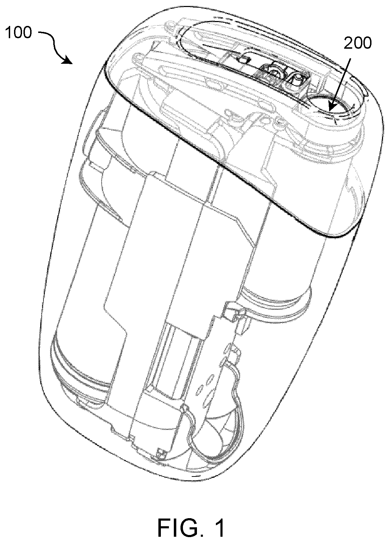

Figure 1 illustrates an aerosol generating device 100 according to an embodiment of the invention. The aerosol generating device 100 is illustrated in an assembled configuration with the internal components visible. The aerosol generating device 100 is a heat-not-burn device, which may also be referred to as a tobacco-vapour device, and comprises a heating chamber 200 configured to receive an aerosol substrate such as a rod of aerosol generating material, e.g. tobacco. The heating chamber 200 is operable to heat, but not burn, the rod of aerosol generating material to produce a vapour or aerosol for inhalation by a user. Of course, the skilled person will appreciate that the aerosol generating device 100 depicted in Figure 1 is simply an exemplary aerosol generating device according to the invention. Other types and configurations of tobacco-vapour products, vaporisers, or electronic cigarettes may also be used as the aerosol generating device according to the invention.

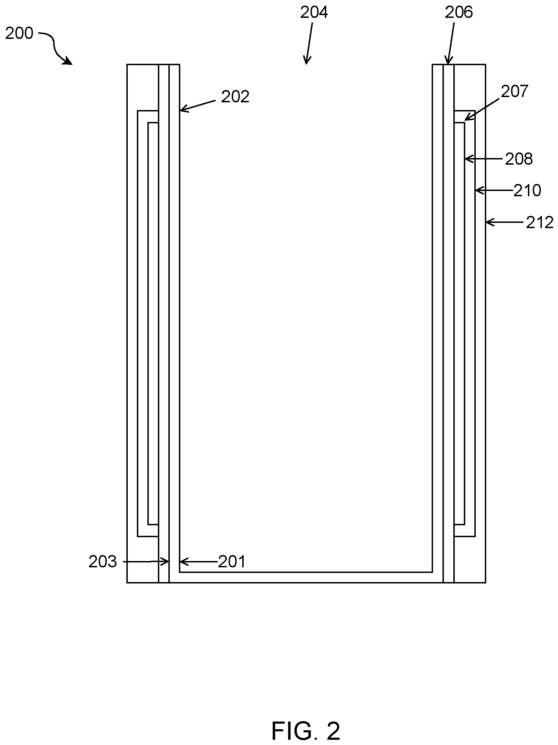

Figure 2 shows a cross-sectional view of a heating chamber 200 according to an embodiment of the invention. The heating chamber 200 comprises a thermally conductive shell 202 configured to hold an aerosol substrate (also referred to as a consumable) therein. In particular, the thermally conductive shell 202 defines a cylindrical cavity in which a rod of aerosol substrate may be positioned. The thermally conductive shell 202 is tubular, e.g. cylindrical, and has an opening 204 positioned at a longitudinal end of the thermally conductive shell 202. In use, the user may insert the aerosol substrate through the opening 204 in the heating chamber 200 such that the aerosol substrate is positioned within the heating chamber 200 and interfaces with an inner surface 201 of the thermally conductive shell 202. The length of the thermally conductive shell 202 may be configured such that a portion of the aerosol substrate protrudes through the opening 204 in the thermally conductive shell 202 (i.e. out of the heating chamber 200) and can be received in the mouth of the user.

The thermally conductive shell 202 preferably comprises a material that allows for efficient heat transfer through a side wall of the thermally conductive shell 202 to the aerosol substrate while maintaining sufficient structural stability. Examples of such materials include steel or stainless steel.

The skilled person will appreciate that the heating chamber 200 (and thermally conductive shell 202) is not limited to being tubular. For example, the thermally conductive shell 202 may be formed as a cuboidal, conical, hemi-spherical or other shaped cavity, and be configured to receive a complementary shaped aerosol substrate. Moreover, in some embodiments, the thermally conductive shell 202 may not entirely surround the aerosol substrate, but instead only contact a limited area of the aerosol substrate.

A layer of electrically insulating material 206 surrounds an outer surface 203 of the thermally conductive shell 202. In particular, the layer of electrically insulating material 206 lies adjacent to (i.e. abuts, contacts) the circumferential outer surface 203 of the thermally conductive shell 202. In Figure 2, the layer of electrically insulating material 206 is depicted as extending along the entire length of the outer surface 203 of the thermally conductive shell 202. However, the skilled person will appreciate that, in other embodiments, the layer of electrically insulating material 206 may only extend along a portion of the length of the thermally conductive shell 202.

The layer of electrically insulating material 206 is deposited using a vacuum deposition technique, and preferably using chemical vapour deposition or plasma enhanced chemical vapour deposition. Thus, the layer of electrically insulating material 206 may be deposited as thin layer, e.g. between 0.3 µm and 5 µm, whilst also exhibiting a high purity and homogeneity.

A thin film heater 207 surrounds the layer of electrically insulating material 206. The thin film heater 207 comprises a heating element 208 that is mounted on a flexible backing film 210. The heating element 208 may comprise one or more heater tracks extending across a surface of the flexible backing film 210. The heating element 208 comprises a heating material suitable for converting electrical energy into heat (such as stainless steel, titanium, nickel, Nichrome, nickel based alloy, silver etc.). In use, power may be supplied to the heating element 208 from a power source such as a battery (not depicted) such that the temperature of the heating element 208 increases and heat energy is transferred across the layer of electrically insulating material 206 to the thermally conductive shell 202. The aerosol substrate received within the heating chamber 200 is conductively heated by the thermally conductive shell 202 to produce an aerosol for inhalation by the user.

The flexible backing film 210 comprises a flexible material preferably having a high dielectric capability and low thermal mass, such as polyimide or polyether ether ketone (PEEK).

The thin film heater 207 is wrapped around the heating chamber 200 in a circumferential direction such that the heating element 208 lies adjacent to (i.e. abuts, contacts) the layer of electrically insulating material 206. That is, the layer of electrically insulating material 206 acts as a barrier to separate the heating element 208 and the thermal conductive shell 202 such that contact between the heating element 208 and the thermally conductive shell 202 is prevented. The flexible backing film 210 lies on an opposing side of the heating element 208 to the layer of electrically insulating material 206, i.e. the heating element 208 is mounted to an inner surface of the flexible backing film 210 with respect to the heating chamber 200.

The skilled person will appreciate that, in alternative embodiments, the heating chamber 200 may not comprise a thin film heater 207. In other words, the heating element 208 may not be formed as a thin film heater, and the heating chamber may not comprise the flexible backing film 210. For example, the heating element 208 may be a stand-alone heating element 208 that is directly applied, e.g. bonded, to the layer of electrically insulating material 206. In particular, the heating element 208 may be wrapped around the heating chamber 200, e.g. in a circumferential direction, such that the heating element 208 interfaces with the layer of electrically insulating material 206.

The layer of electrically insulating material 206 preferably comprises a material with a high electrical breakdown voltage and a high thermal conductivity. Thus, the layer of electrically insulating material 206 prevents a short circuit occurring between the heating element 208 and the thermally conductive shell 202, whilst allowing an efficient transfer of heat from the heating element 208 to the thermally conductive shell 202. The skilled person will appreciate that the thermally conductive shell 202 is not a resistive heater, and therefore should not receive a current. The layer of electrically insulating material 206 separates the heating element 208 and the thermally conductive shell 202 and ensures that a current does not flow from the heating element 208 to the thermally conductive shell 202. Moreover, the skilled person will appreciate that, as the layer of electrically insulating material 206 has a low thickness, the efficiency of heat transfer from the heating element 208 to the thermally conductive shell 202 remains high.

Examples of suitable materials for the layer of electrically insulating material 206 include silica (SiO₂), diamond, and diamond-like-carbon (DLC), which can all be deposited using chemical vapour deposition due to their high temperature stability and resistance to degassing.

A heat shrink film 212 is preferably wrapped around the heating element 208 (e.g. the thin film heater 207) in a circumferential direction, such that the heating element 208 is secured against the layer of electrically insulating material 206. In other words, the heat shrink film 212 acts as an external layer which surrounds the exterior of the heating chamber 200, thereby consolidating the structure and ensuring that the heating element 208 maintains contact with the layer of electrically insulating material 206. In some examples, the heat shrink film 212 may comprise polyimide or polyether ether ketone (PEEK). Such materials provide high electrical and thermal conductivity, which is desirable for the external layer of the heating chamber 200.

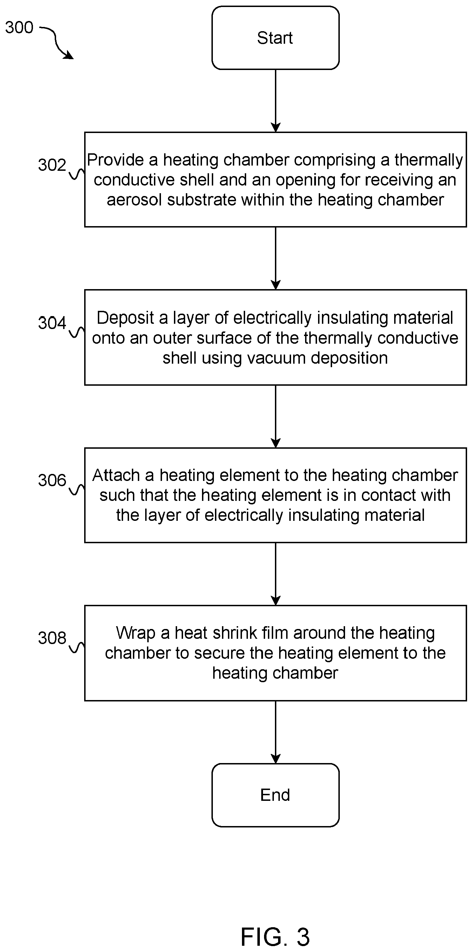

Figure 3 illustrates a flow chart which is a method 300 of manufacturing a heating chamber according to an embodiment of the invention.

The method 300 begins at step 302, wherein a heating chamber 200 comprising a thermally conductive shell 202 and an opening 204 for receiving an aerosol substrate within the heating chamber 200 is provided. At step 304, a layer of electrically insulating material 206 is deposited onto an outer surface 203 of the thermally conductive shell 202 using vacuum deposition. Vacuum deposition is carried out significantly below atmospheric pressure, i.e. vacuum. Preferably, the layer of electrically insulating material 206 is deposited using chemical vapour deposition. However, in some examples, the layer of electrically insulating material 206 may be deposited using physical vapour deposition.

Chemical vapour deposition is a technique in which a substrate is exposed to one or more volatile precursors in a vacuum (or low-pressure plasma) environment, which react and/or decompose on a surface of the substrate to produce a thin film deposit. In this case, the substrate is the thermally conductive shell 202 and the layer of electrically insulating material 206 is the thin film deposit.

In some embodiments, plasma enhanced vapour deposition may be used to form the layer of electrically insulating material 206. Plasma enhanced vapour deposition utilizes a plasma to provide some of the energy which is required for the deposition reaction to occur. In particular, deposition is achieved by introducing reactant gases between parallel electrodes, wherein a capacitive coupling between the electrodes excites the reactant gases into a plasma. This induces a chemical reaction and results in the reaction product (i.e. the electrically insulating material 206) being deposited on the substrate (i.e. the thermally conductive shell 202). Advantageously, plasma enhanced vapour deposition takes place at lower temperatures than other chemical vapour deposition techniques.

In one example, a radio frequency electrical discharge between two electrodes may be used to create a plasma from a carrier gas comprising CH₄. The resultant chemical reaction deposits a thin film comprising diamond or diamond-like-carbon (DLC) on the thermally conductive shell 202. The thin film corresponds to the layer of electrically insulating material 206.

In another example, a microwave frequency electrical discharge between two electrodes may be used to excite oxygen to form a plasma. A mixture of silane (SiH₄) diluted in a carrier gas, such as argon, is then introduced in an afterglow of the plasma. For example, a mixture of 5% silane in argon may be introduced. The resultant chemical reaction deposits a thin film comprising silicon oxide (e.g. silicon dioxide) on the thermally conductive shell 202. The thin film corresponds to the layer of electrically insulating material 206. For example, the deposited thin film may comprise a functionalized silica-like coating, e.g. a-SiO_{X}:CH_{Y}.

The chemical vapour deposition process is continued until a desired thickness of the layer of electrically insulating material 206 is deposited, e.g. between 0.5 µm and 5 µm.

At step 306, the heating element 208 is attached to the heating chamber 200 such that the heating element 208 is in contact with the layer of electrically insulating material 206. That is, the heating element 208 is positioned adjacent to an outer surface of the layer of electrically insulating material 206 so that the heating element 208 interfaces with the layer of electrically insulating material 206. In use, the heating element 208 may be operated to transfer heat across the electrically insulating layer 206 to the thermally conductive shell 202. The layer of electrically insulating material 206 separates the heating element 208 and the thermally conductive shell 202 so that they are not in contact, thereby preventing current from flowing from the heating element 208 to the thermally conductive shell 202.

In some embodiments, such as the embodiment depicted in Figure 2, the heating element 208 is comprised within a thin film heater 207. In this case, the method 300 further comprises providing the thin film heater 207 comprising the heating element 208 and a flexible backing film 210 on which the heating element 208 is supported, and attaching the thin film heater 207 to the heating chamber 200 with the heating element 208 against the layer of electrically insulating material 206. Alternatively, in other embodiments, the heating element 208 may be a stand-alone heating element 208 and a thin film heater 207 may not be provided.

In the depicted embodiment of Figure 2, wherein the heating chamber 200 is tubular, the heating element 208 is wrapped around the layer of electrically insulating material 206 of the heating chamber 200 in a circumferential direction. In particular, the thin film heater 207 comprising the heating element 208 and the flexible backing film 210 is wrapped around the layer of electrically insulating material 206 of the heating chamber 200. The flexible backing film 210 is located on an opposing side of the heating element 208 to the layer of electrically insulating material 206, thereby providing structural support. Of course, the skilled person will appreciate that, in embodiments wherein the heating element 208 is not comprised within a thin film heater 207, the heating element 208 may be wrapped around the heating chamber 200 without the flexible backing film 210. In some examples, the heating element 208 may be supported on a carrier film, and the heating element 208 wrapped around the heating chamber 200 using the carrier film. Once the heating element 208 is correctly positioned against the layer of electrically insulating material 206, the carrier film may be removed.

At step 308, a heat shrink film 212 is preferably wrapped around the heating chamber 200 to secure the heating element 208 to the heating chamber 200. For example, in embodiments wherein the heating chamber 200 comprises the thin film heater 207, the heat shrink film 212 is manipulated to surround the flexible backing film 210 on which the heating element 208 is attached. Alternatively, in embodiments wherein the heating element 208 is not comprised within a thin film heater 207, the heat shrink film 212 may be manipulated to surround and interface with heating element 208. As depicted in Figure 2, the heat shrink film 212 may also extend beyond the length of heating element 208 and/or the flexible backing film 210 and overlap with the layer of electrically insulating layer 206.

Once the heating chamber 200 and the heating element 208 is wrapped in the heat shrink film 212, heat may be applied to the heat shrink film 212 such that the heat shrink film 212 shrinks and tightens around the heating chamber 200. This ensures that the heating element 208 (e.g. the thin film heater 207) is securely attached to the heating chamber 200 and, in particular, to the layer of electrically insulating material 206.

## Claims

1. A method (300) of manufacturing a heating chamber (200) for an aerosol generating device (100), the method comprising:
providing (302) a heating chamber (200) comprising a thermally conductive shell (202) and an opening (204) for receiving an aerosol substrate within the heating chamber (200);
depositing (304) a layer of electrically insulating material (206) onto an outer surface of the thermally conductive shell (202) of the heating chamber (200) using vacuum deposition;
providing a thin film heater (207) comprising a heating element (208) and a flexible backing film (210) on which the heating element (208) is supported, wherein the flexible backing film (210) comprises polyimide or poly ether ketone (PEEK)
attaching (306) the thin film heater (207) to the heating chamber (200) such that the heating element (208) is in contact with the layer of electrically insulating material (206),
wherein the layer of electrically insulating material (206) prevents any contact between the heating element (208) and the thermally conductive shell (202).

2. The method of claim 1, wherein depositing the layer of electrically insulating material (206) using vacuum deposition comprises:
depositing the layer of electrically insulating material (206) using chemical vapour deposition.

3. The method of claim 1 or claim 2, wherein the electrically insulating material (206) comprises at least one of:
silicon oxide;
diamond; and
diamond-like carbon (DLC).

4. The method of any preceding claim, wherein the electrically insulating material (206) comprises a-SiO_{X}:CH_{Y}.

5. The method of any preceding claim, wherein the thickness of the deposited layer of electrically insulating material (206) is between 0.3 µm and 5 µm.

6. The method of any preceding claim, wherein the heating chamber (200) is a tubular heating chamber comprising a tubular thermally conductive shell (202) and the method comprises wrapping the thin film heater (207) around the heating chamber (200) with the heating element (208) against the layer of electrically insulating material (206).

7. The method of claim 6, further comprising:
wrapping a heat shrink film around the heating chamber (200) to secure the heating element (208) to the heating chamber (200).

8. The method of any preceding claim, further comprising:
depositing the layer of electrically insulating material (206) using plasma enhanced chemical vapour deposition.

9. The method of claim 8, wherein the method comprises:
using a radio frequency electrical excitation source and a carrier gas comprising CH₄ to deposit a thin film comprising diamond-like-carbon (DLC) or diamond.

10. The method of claim 8, wherein the method comprises:
using a microwave frequency electrical excitation source and a carrier gas comprising silane to deposit a thin film comprising silicon oxide.

11. A heating chamber (200) for an aerosol generating device (100) manufactured by the method of any preceding claim.

12. An aerosol generating device (100) comprising the heating chamber (200) of claim 11.

## Patentansprüche

1. Verfahren (300) zur Herstellung einer Heizkammer (200) für eine Aerosolerzeugungsvorrichtung (100), wobei das Verfahren umfasst:
Bereitstellen (302) einer Heizkammer (200), die eine wärmeleitfähige Hülle (202) und eine Öffnung (204) zur Aufnahme eines Aerosolsubstrats innerhalb der Heizkammer (200) umfasst;
Aufbringen (304) einer Schicht aus elektrisch isolierendem Material (206) auf eine Außenfläche der wärmeleitfähigen Hülle (202) der Heizkammer (200) unter Verwendung von Vakuumaufdampfung;
Bereitstellen einer Dünnschichtheizung (207), die ein Heizelement (208) und eine flexible Trägerfolie (210) umfasst, auf der das Heizelement (208) getragen wird, wobei die flexible Trägerfolie (210) Polyimid oder Polyetherketon (PEEK) zum Anbringen (306) der Dünnschichtheizung (207) an die Heizkammer (200) so umfasst, dass das Heizelement (208) mit der Schicht aus elektrisch isolierendem Material (206) in Kontakt ist,
wobei die Schicht aus elektrisch isolierendem Material (206) irgendeinen Kontakt zwischen dem Heizelement (208) und der wärmeleitfähigen Hülle (202) verhindert.

2. Verfahren nach Anspruch 1, wobei das Aufbringen der Schicht aus elektrisch isolierendem Material (206) unter Verwendung von Vakuumaufdampfung umfasst:
Aufbringen der Schicht aus elektrisch isolierendem Material (206) unter Verwendung von Vakuumaufdampfung.

3. Verfahren nach Anspruch 1 oder Anspruch 2, wobei das elektrisch isolierende Material (206) mindestens eins von Folgenden umfasst:
Siliziumoxid;
Diamant; und
diamantähnlichem Kohlenstoff (DLC).

4. Verfahren irgendeinem vorhergehenden Anspruch, wobei das elektrisch isolierende Material (206) a-SiOx:CHy umfasst:

5. Verfahren nach irgendeinem vorhergehenden Anspruch, wobei die Dicke der aufgebrachten Schicht aus elektrisch isolierendem Material (206) zwischen 0,3 µm und 5 µm liegt.

6. Verfahren nach irgendeinem vorhergehenden Anspruch, wobei die Heizkammer (200) eine röhrenförmige Heizkammer ist, die eine röhrenförmige wärmeleitfähige Hülle (202) umfasst, und das Verfahren die Wicklung der Dünnschichtheizung (207) um die Heizkammer (200) umfasst, wobei das Heizelement (208) gegen die Schicht aus elektrisch isolierendem Material (206) anliegt.

7. Verfahren nach Anspruch 6, ferner umfassend:
Wickeln einer Schrumpffolie um die Heizkammer (200), um das Heizelement (208) an der Heizkammer (200) zu befestigen.

8. Verfahren nach irgendeinem vorhergehenden Anspruch, ferner umfassend:
Aufbringen der Schicht aus elektrisch isolierendem Material (206) unter Verwendung plasmaunterstützter chemischer Abscheidung aus der Gasphase.

9. Verfahren nach Anspruch 8, wobei das Verfahren umfasst:
Verwendung einer elektrischen Hochfrequenz-Erregungsquelle und eines CH₄ enthaltenden Trägergases, um einen dünnen Film, der diamantähnlichen Kohlenstoff (DLC) oder Diamant umfasst, aufzutragen.

10. Verfahren nach Anspruch 8, wobei das Verfahren umfasst:
Verwendung einer elektrischen Mikrowellenfrequenz-Erregungsquelle und eines Silan enthaltenden Trägergases, um einen Siliziumoxid enthaltenden dünnen Film aufzutragen.

11. Heizkammer (200) für eine Aerosolerzeugungsvorrichtung (100), die gemäß dem Verfahren nach irgendeinem vorhergehenden Anspruch hergestellt wurde.

12. Aerosolerzeugungsvorrichtung (100), welche die Heizkammer (200) nach Anspruch 11 umfasst.

## Revendications

1. Procédé (300) de fabrication d'une chambre de chauffage (200) pour un dispositif de génération d'aérosol (100), le procédé comprenant :
l'agencement (302) d'une chambre de chauffage (200) comprenant une enveloppe thermo-conductrice (202) et une ouverture (204) pour recevoir un substrat d'aérosol au sein de la chambre de chauffage (200) ;
le dépôt (304) d'une couche de matériau électro-isolant (206) sur une surface extérieure de l'enveloppe thermo-conductrice (202) de la chambre de chauffage (200) par dépôt sous vide ;
l'agencement d'un film mince chauffant (207) comprenant un élément chauffant (208) et un film support flexible (210) sur lequel l'élément chauffant (208) est supporté, le film support flexible (210) comprenant du polyimide ou du polyéthercétone (PEEK) ;
la fixation (306) du film mince chauffant (207) sur la chambre de chauffage (200), de sorte que l'élément chauffant (208) se trouve au contact de la couche de matériau électro-isolant (206),
la couche de matériau électro-isolant (206) empêchant tout contact entre l'élément chauffant (208) et l'enveloppe thermo-conductrice (202).

2. Procédé selon la revendication 1, le dépôt de la couche de matériau électro-isolant (206) par dépôt sous vide comprenant :
le dépôt de la couche de matériau électro-isolant (206) par dépôt chimique en phase vapeur.

3. Procédé selon la revendication 1 ou la revendication 2, le matériau électro-isolant (206) comprenant au moins un des suivants :
oxyde de silicium ;
diamant ; ou
carbone de type diamant (DLC).

4. Procédé selon une quelconque des revendications précédentes, le matériau électro-isolant (206) comprenant a-SiOx:CHy.

5. Procédé selon une quelconque des revendications précédentes, l'épaisseur de la couche déposée de matériau électro-isolant (206) étant comprise entre 0,3 µm et 5 µm.

6. Procédé selon une quelconque des revendications précédentes, la chambre de chauffage (200) étant une chambre de chauffage tubulaire comprenant une enveloppe thermo-conductrice tubulaire (202), et le procédé comprenant l'enveloppement du film mince chauffant (207) autour de la chambre de chauffage (200) avec l'élément chauffant (208) contre la couche de matériau électro-isolant (206).

7. Procédé selon la revendication 6, comprenant l'enveloppement d'un film thermo-rétractable autour de la chambre de chauffage (200) afin de fixer l'élément chauffant (208) sur la chambre de chauffage (200).

8. Procédé selon une quelconque des revendications précédentes, comprenant en outre le dépôt de la couche de matériau électro-isolant (206) par dépôt chimique en phase vapeur amélioré au plasma.

9. Procédé selon la revendication 8, le procédé comprenant l'emploi d'une source d'excitation électrique par radiofréquence et un gaz porteur comprenant du CH₄ pour déposer un film mince comprenant du carbone de type diamant (DLC) ou du diamant.

10. Procédé selon la revendication 8, le procédé comprenant l'emploi d'une source d'excitation électrique en hyperfréquence et un gaz porteur comprenant du silane pour déposer un film mince comprenant de l'oxyde de silicium.

11. Chambre de chauffage (200) pour un dispositif de génération d'aérosol (100) fabriqué par la méthode selon une quelconque des revendications précédentes.

12. Dispositif de génération d'aérosol (100) comprenant la chambre de chauffage (200) selon la revendication 11.
